# EUROPEAN PATENT SPECIFICATION

(11) **EP 1 643 824 B1**
(45) Date of publication and mention of the grant of the patent: **23.03.2011**
(21) Application number: 05109005.8
(22) Date of filing: 29.09.2005
(51) Int. Cl.: H05K 9/00

(54) **Tuner assembly**
Tuneraufbau
Assemblage d'un syntoniseur

(30) Priority: 30.09.2004 JP 2004288458
(43) Date of publication of application: 05.04.2006
(73) Proprietor: KABUSHIKI KAISHA TOSHIBA, Tokyo 105-8001 (JP)
(72) Inventor: Takashima, Tadao, Tokyo 105-8001 (JP)
(74) Representative: Henkel, Feiler & Hänzel

(56) References cited:
- EP-A2- 1 246 517
- DE-A1- 3 335 664
- US-A- 5 520 554
- US-A1- 2003 094 299
- US-A1- 2003 107 876

## Description

### RELATED APPLICATIONS

The present disclosure relates to the subject matter contained in Japanese Patent Application No. 2004-288458 filed on September 30, 2004.

### BACKGROUND

### Field of the Invention

The present invention relates to a tuner for receiving television signals, and more particularly to a tuner having an input terminal to which television signals are input by way of a cable, and being capable of reducing influence of a disturbing wave flowing into the input terminal from a grounded side of the cable.

### Description of the Related Art

A tuner for a television receiver or a CATV is generally configured such that a tuner circuit is formed in a tuner cabinet formed by a metal case; and by virtue of a shielding effect of the tuner cabinet, influence of a disturbing wave from the outside is reduced.

An input terminal, to which a cable is to be inserted, is disposed on a side wall of the tuner cabinet of the tuner for connection with a cable from an antenna or a CATV. The input terminal, formed from a cylindrical metal material, is constructed so as to have a signal terminal inside and a ground terminal outside.

In the tuner of the related art, the circuit inside the tuner is shielded by the cabinet. However, in some cases, a disturbing wave flows into the grounded side of the input terminal from the grounded side of the cable. The disturbing wave flows into the circuit inside the tuner cabinet by way of the grounded side, thereby inducing noise and image distortion. In other cases, surge current induced by static electricity, lightning, or the like flows, whereby the tuner circuit is broken down.

To cope with such a disturbing wave, an example having the following configuration is disclosed in JP-A-2000-196476. A tuner --whose input terminal section projects outside a metal case of the tuner-- includes an insulating body which provides electrical insulation between a ground terminal of the input terminal section and the metal case, and the ground terminal of the input terminal section is connected to a ground electrode side of a power circuit by way of a capacitor. However, the configuration including such an insulating body has a problem that the structure of the terminal is complicated and is of low practicality.

### SUMMARY

In the above-mentioned tuner of the related art, in some cases, a disturbing wave flows into the grounded side of the input terminal from the grounded side of the cable. Accordingly, in some cases, the disturbing wave flows into the circuit inside the tuner cabinet by way of the grounded side of the input terminal, thereby inducing noise and image distortion. In addition, the example disclosed in JP-A-2000-196476 has a problem that the structure is complicated.

The present invention provides a tuner that is capable of reducing influence of a disturbing wave by means of a simple structure.

According to a first aspect of the invention, there is provided a tuner including: a tuner main body that has a cabinet and a tuner circuit provided within the cabinet; an input terminal that is disposed on one side face of the cabinet and, the input terminal being input a television signal by way of a cable connected thereto and having a cylindrical ground terminal and a signal terminal provided in the ground terminal; a circuit board, to one face of which the tuner main body is attached so as to locate the input terminal on an edge of the circuit board, and on which a ground pattern is formed adjacent to the edge of the circuit board; and a conductive member that is attached to the circuit board to pinch the edge of the circuit board, wherein either the conductive member is brought into contact with the ground terminal and with the ground pattern, or

; a solder-affixed portion formed with a solder is disposed at a portion of the ground pattern at a position where the input terminal is disposed; the input terminal is formed so as to project beyond the edge of the circuit board, and the conductive member is brought into contact with the ground terminal and with the solder formed at the solder-affixed portion.

### BRIEF DESCRIPTION OF THE DRAWINGS

In the accompanying drawings:
Figs. 1A and 1B are perspective views showing an embodiment of a tuner of an embodiment;
Fig. 2A is a side view showing the configuration of the tuner of the invention, and Fig. 2B is a front view of the tuner;
Fig. 3 is a perspective view showing the structure of a clip for use in the tuner; and
Figs. 4A and 4B are characteristic diagrams for explaining immunity provided by the tuner.

### DETAILED DESCRIPTION OF THE EMBODIMENT

Hereinafter, an embodiment of the invention will be described by reference to the drawings in detail.

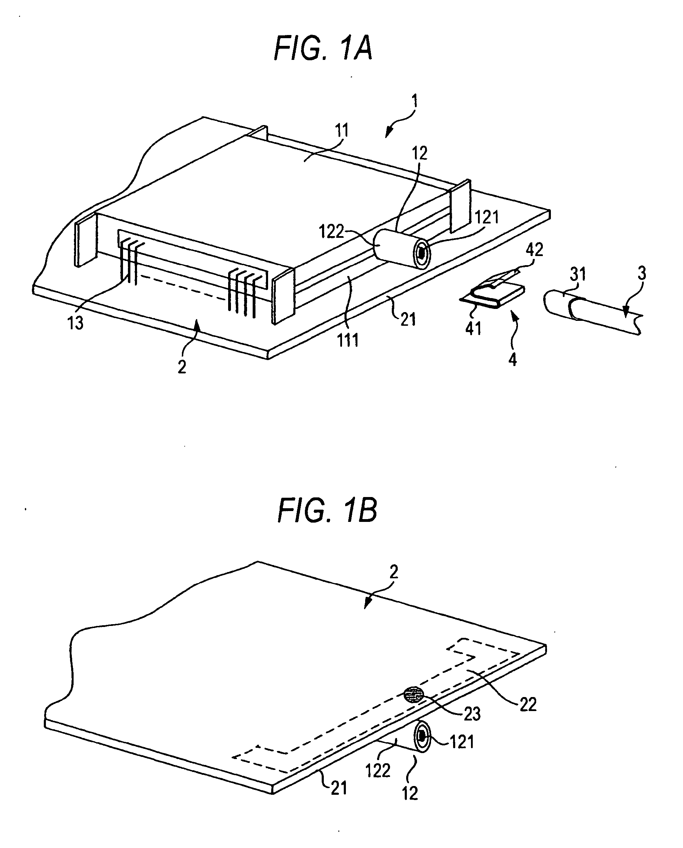

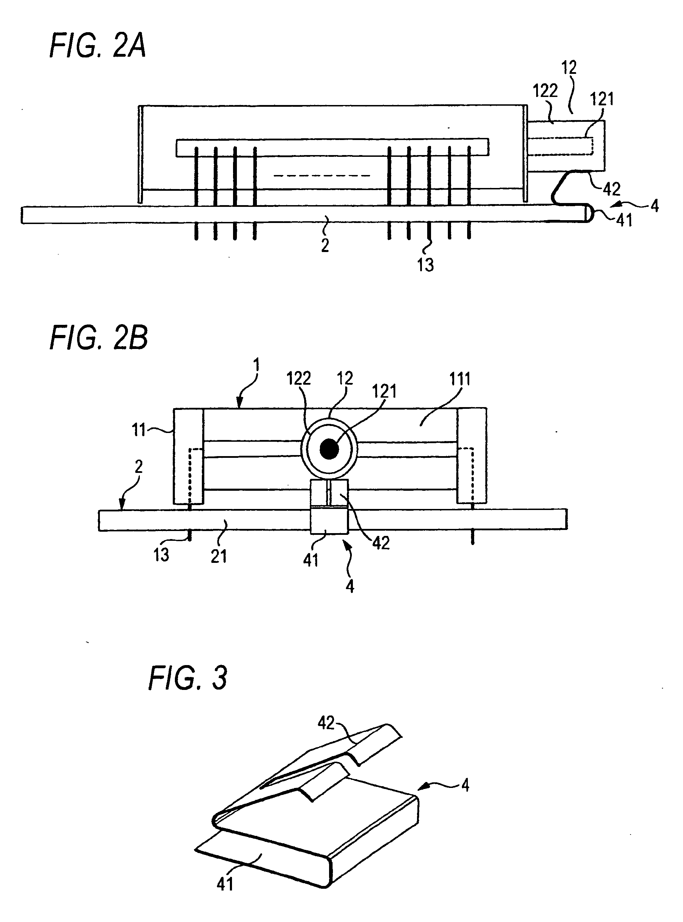

Figs. 1A and 1B are perspective views showing the external appearance of a tuner according to an embodiment of the invention. Fig. 1A shows the configuration of a tuner section attached to a surface of a circuit board. Fig. 1B shows a back shape of the circuit board. Fig. 2A shows a side view of the tuner, and Fig. 2B shows a front view of the same. Fig. 3 is a perspective view of a specific example of a conductive clip employed in the invention.

In Fig. 1A, reference numeral 1 denotes a tuner main body, and a tuner circuit is formed inside a metal cabinet 11. The cabinet 11 has a cylindrical input terminal 12 projecting from a frontal plate 111. A signal terminal 121 is disposed inside the input terminal 12, and an outer periphery of the input terminal forms a ground terminal 122.

A plurality of connecting terminals 13 project from a side face of the cabinet 11. A circuit inside the cabinet 11 is connected with a circuit board 2 by way of the terminals 13. A cable 3 from an antenna, or the like, can be connected to the input terminal 12. By means of inserting a connecting plug 31 disposed on an end section of the cable 3 into the input terminal 12, television signals are input and introduced to the circuit section of the tuner.

The circuit board 2 is attached to the tuner main body 1 so that a tip end of the input terminal 12 projects beyond an edge 21 of the circuit board 2. A conductive clip 4 is attached to the edge 21 of the board 2 at a section directly below the input terminal 12.

Fig. 2A is a side view showing a state where the clip 4 is attached. Fig. 2B is a front view of the same as viewed from the input terminal 12 side. Fig. 3 shows an enlarged configuration of the clip 4. The clip 4 comprises a pinching section 41 for pinching the board 2, and a contact section 42 which extends from the pinching section 41 to the input terminal 12 side so as to contact the ground terminal 122. The entirety of the clip 4 includes a resilient, conductive material.

On the back face of the board 2, in the vicinity of the edge 21, a ground pattern 22 is formed. The entirety of the ground pattern 22 is covered by solder resist ink. However, a portion of the pattern corresponding to the input terminal 12 is not covered by the solder resist ink, and is exposed. Soldering by means of cream solder, or the like, is applied to the exposed portion, and solder 23 is affixed thereto. The pinching section 41 of the conductive clip 4 is brought into contact with the solder 23.

Accordingly, when the cable 3 is inserted into the input terminal 12 to effect connection, the grounded side of the cable 3 and the ground terminal 122 of the input terminal 12 are grounded to the ground pattern 22 of the circuit board 2 by way of the clip 4. As a result, a disturbing wave flowing in from the grounded side of the cable 3 is absorbed in the ground pattern 22 rather than flowing into the tuner main body 1. In addition, surge current generated upon lightning striking and by way of the antenna and the cable, or the like, is also absorbed in the ground pattern 22 of the circuit board 2. Therefore, surge breakdown caused by static electricity, lightning, or the like can also be prevented.

Furthermore, the input terminal 12 projects beyond the edge 21 of the circuit board 2. Accordingly, attachment location of the clip 4 is facilitated, thereby facilitating insertion of the cable 3.

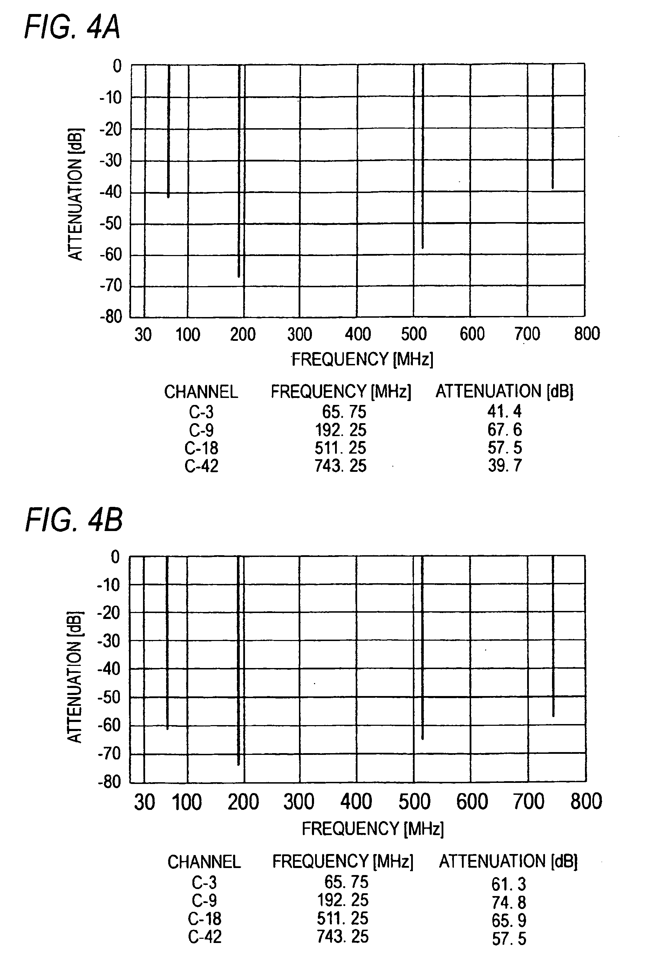

Figs. 4A and 4B are characteristic diagrams showing effects of performance improvement attained by the embodiment of the invention. Fig. 4A shows a characteristic for a case where the clip 4 is not included. Fig. 4B shows a characteristic for a case where the clip 4 is attached. In each of Figs. 4A and 4B, the horizontal axis denotes a frequency (MHz) and the vertical axis denotes attenuation in a disturbing wave. Specifically, the vertical axis indicates attenuations of a disturbing wave of a channel 3 (C-3), channel 9 (C-9), channel 18 (C-18), and channel 42 (C-42) employed in China, while taking an attenuation of a desired wave as 0 [dB] in a case where the provided disturbing wave is a signal whose frequency is offset from a frequency of a desired channel by a predetermined frequency interval (for instance, approximately 1 MHz).

For instance, according to a Chinese national standard (GB/T 9383)*, attenuation of a disturbing wave is specified as -50 [dB] or lower. However, as shown in Fig. 4A, when the clip 4 is not attached, an attenuation of (C-3) is -41.4 [dB] and that of (C-42) is -39.7 [dB]. That is, the specification of -50 [dB] or lower is not satisfied.

In contrast, when the clip 4 is attached, as shown in Fig. 4B, an attenuation of the disturbing wave does not exceed -50 [dB] in any of (C-3), (C-9), (C-18), and (C-42) .

Thus, according to the embodiment, influence of a disturbing wave can be reduced, to thus improve immunity by merely attaching a clip of simple structure. In addition, there is also provided a protection effect against surge breakdown due to lightning, static electricity, or the like.

Meanwhile, since the clip 4 can be easily attached and removed, the clip 4 can be removed when influence of a disturbing wave is of a negligible level. In addition, since the solder 23 is affixed to a portion of the ground pattern to be brought into contact with the clip 4, more secure contact with the clip 4 can be achieved.

The clip 4 is not limited to the shape shown in Fig. 3, and may be formed into another shape, so long as the clip 4 can pinch the board 2 and be brought into contact with the input terminal 12 and the ground pattern 22. The ground pattern is not necessarily formed on the back face of the circuit board 2, and may be formed on the surface thereof, in the vicinity of the edge 21.

As described with reference to the embodiment, there is provided a tuner including: a tuner main body formed from a tuner circuit provided within a cabinet; a cylindrical input terminal which is disposed on one side face of the cabinet, to which television signals are input by way of a cable, which has a signal terminal inside, and whose outer periphery constitutes a grounded side; a circuit board, one face of which is attached to the tuner main body so as to locate the input terminal on an edge of the board, and on which a ground pattern is formed adjacent to the edge of the board; and a conductive member which is attached to the circuit board so as to pinch the edge of the board, and which is brought into contact with the grounded side of the input terminal and with the ground pattern.

There is also provided a tuner including: a tuner main body constructed such that a tuner circuit is formed within a cabinet; a cylindrical input terminal which is disposed on one side face of the cabinet, receives an input of a television signals by way of a cable, and has a signal terminal therein, and whose outer periphery constitutes a grounded side; a circuit board whose one face is attached to the tuner main body such that the input terminal is located on an edge of the board and projects beyond the edge, and which has a ground pattern formed thereon and adjacent to the edge of the board; a solder-affixed portion disposed at a portion of the ground pattern corresponding to the input terminal; and a resilient conductive member which is attached to the circuit board so as to pinch the edge of the board and which is brought into contact with the grounded side of the input terminal and with the ground pattern.

According to the configuration described above, the tuner can be reduced of influence of a disturbing wave, and which is effective for immunity and serge protection by virtue of employing a conductive clip which can be attached by a single operation.

The foregoing description of the embodiment of the invention has been presented for purposes of illustration and description. It is not intended to be exhaustive or to limit the invention to the precise form disclosed, and modifications and variations are possible in light of the above teachings or may be acquired from practice of the invention. The embodiment is chosen and described in order to explain the principles of the invention and its practical application program to enable one skilled in the art to utilize the invention in various embodiments and with various modifications as are suited to the particular use contemplated. It is intended that the scope of the invention be defined by the claims appended hereto, and their equivalents.

## Claims

1. A tuner comprising:
a tuner main body (1) that has a cabinet (11) and a tuner circuit provided within the cabinet;
an input terminal (12) that is disposed on one side face of the cabinet (11) and, the input terminal (12) being adapted to receive a television signal by way of a cable (3) connected thereto and having a cylindrical ground terminal (122) and a signal terminal (121) provided in the ground terminal (122);
a circuit board (2) , to one face of which the tuner main body (1) is attached so as to locate the input terminal (12) on an edge (21) of the circuit board (2), and on which a ground pattern (22) is formed adjacent to the edge (21) of the circuit board (2); and **characterized by** comprising
a conductive member (4) that is attached to the circuit board (2) to pinch the edge (21) of the circuit board (2), wherein either
a) the conductive member (4) is in contact with the ground terminal (122) and with the ground pattern (22) ; or
b) a solder-affixed portion formed with a solder (23) is disposed at a portion of the ground pattern (22) at a position where the input terminal (12) is disposed, the input terminal (12) is formed so as to project beyond the edge of the circuit board (2), and the conductive member (4) is in contact with the ground terminal (122) and with the solder (23) formed at the solder-affixed portion.

2. The tuner according to claim 1, **characterized in that** the tuner main body (1) is attached to the circuit board (2) so that the input terminal (12) projects beyond the edge of the circuit board (2).

3. The tuner according to claim 1, **characterized in that** the conductive member (4) includes:
a resilient pinching (41) section that pinches the edge (21) of the circuit board (2); and
a projecting section (42) that projects from the pinching section toward the ground terminal (122).

## Patentansprüche

1. Tuner mit:
einem Tunerhauptkörper (1), der ein Gehäuse (11) und eine in dem Gehäuse vorgesehene Tunerschaltung hat;
einem Eingangsanschluss (12), der auf einer Seitenfläche des Gehäuses (11) angebracht ist, und wobei der Eingangsanschluss (12) zum Empfang eines Fernsehsignals über ein Kabel (3) ausgestaltet ist, das mit diesem verbunden werden kann, und mit einem zylindrischen Masseanschluss (122) und einem Signalanschluss (121), der in dem Masseanschluss (122) vorgesehen ist;
einer Platine (2) mit deren einen Seite der Tunerhauptkörper (1) verbunden ist, um so den Eingangsanschluss (12) an einer Kante (21) der Schaltungstafel (2) anzuordnen, und auf der ein Massemuster (22) benachbart der Kante (21) der Platine (2) ausgebildet ist, und **gekennzeichnet durch**:
ein leitfähiges Element (4), das an der Platine (2) angebracht ist, um die Kante (21) der Platine (2) zu klemmen, wobei entweder:
a) das leitfähige Element (4) in Kontakt mit dem Masseanschluss (122) und mit dem Massemuster (22) steht; oder
b) nach einem mit Lötmittel versehenen Abschnitt, der durch ein Lötmittel (23) gebildet ist, an einem Abschnitt des Masse-Musters an einer Position angeordnet ist, an der der Eingangsanschluss (12) angeordnet ist, wobei der Eingangsanschluss (12) ausgebildet ist, um sich über die Kante der Platine (2) hinaus zu erstrecken, und wobei das leitfähige Element (4) in Kontakt mit dem Masseanschluss (122) und mit dem Lötmittel (23) ist, das auf dem mit Lötmittel versehenen Abschnitt ausgebildet ist.

2. Tuner nach Anspruch 1, **dadurch gekennzeichnet, dass** der Tunerhauptkörper (1) an der Platine (2) so angebracht ist, dass der Eingangsanschluss (12) über die Kante der Platine (2) hinausragt.

3. Tuner nach Anspruch 1, **dadurch gekennzeichnet, dass** das leitfähige Element (4) enthält:
einen abziehbaren Klemmabschnitt (41), der die Kante (21) der Schalttafel (2) einklemmt;
einen hervorstehenden Abschnitt (42), der von dem Klemmabschnitt hinzu dem Masseabschnitt (122) hervorsteht.

## Revendications

1. Syntoniseur comprenant :
un corps principal de syntoniseur (1) qui comporte un boîtier (11) et un circuit de syntoniseur prévu dans le boîtier ;
une borne d'entrée (12) qui est disposée sur une face latérale du boîtier (11) et la borne d'entrée (12) étant conçue pour recevoir un signal de télévision au moyen d'un câble (3) connecté à celle-ci et comportant une borne de masse (122) cylindrique et une borne de signal (121) prévue dans la borne de masse (122) ;
une carte de circuit (2), à une face de laquelle le corps principal de syntoniseur (1) est fixé de manière à positionner la borne d'entrée (12) sur un bord (21) de la carte de circuit (2), et sur laquelle un motif de masse (22) est formé adjacent au bord (21) de la carte de circuit (2) ; et **caractérisé en ce qu'**il comprend :
un élément conducteur (4) qui est fixé à la carte de circuit (2) pour pincer le bord (21) de la carte de circuit (2), dans lequel soit
a) l'élément conducteur (4) est en contact avec la borne de masse (122) et avec le motif de masse (22), soit
b) une partie de soudure apposée comportant une soudure (23) est disposée au niveau d'une partie du motif de masse (22) à une position où la borne d'entrée (12) est disposée, la borne d'entrée (12) est formée de manière à faire saillie au-delà du bord de la carte de circuit (2), et l'élément conducteur (4) est en contact avec la borne de masse (122) et avec la soudure (23) formée au niveau de la partie de soudure apposée.

2. Syntoniseur selon la revendication 1, **caractérisé en ce que** le corps principal de syntoniseur (1) est fixé à la carte de circuit (2) de sorte que la borne d'entrée (12) fasse saillie au-delà du bord de la carte de circuit (2).

3. Syntoniseur selon la revendication 1, **caractérisé en ce que** l'élément conducteur (4) comprend :
une section de pincement (41) élastique qui pince le bord (21) de la carte de circuit (2) ; et
une section saillante (42) qui fait saillie de la section de pincement vers la borne de masse (122).
